# EUROPÄISCHE PATENTSCHRIFT

(11) **EP 0 699 017 B1**
(45) Veröffentlichungstag und Bekanntmachung des Hinweises auf die Patenterteilung: **23.06.1999**
(21) Anmeldenummer: 95113062.4
(22) Anmeldetag: 19.08.1995
(51) Int. Cl.: H05K 5/00, B60R 16/02, H05K 1/00

(54) **Elektrisches oder elektronisches Gerät für ein Kraftfahrzeug**
Electrical or electronic device for a motor vehicle
Dispositif électrique ou électronique pour un véhicule

(30) Priorität: 24.08.1994 DE 4429983
(43) Veröffentlichungstag der Anmeldung: 28.02.1996
(73) Patentinhaber: Hella KG Hueck & Co., 59552 Lippstadt (DE)
(72) Erfinder: Beckort, Bruno, D-59558 Lippstadt (DE); Trippe, Horst, D-59557 Lippstadt (DE)

(56) Entgegenhaltungen:
- GB-A- 942 236
- GB-A- 1 127 358
- US-A- 4 843 520

## Beschreibung

Die Erfindung betrifft ein elektrisches oder elektronisches Gerät für ein Kraftfahrzeug, mit einer biegsamen Leiterplatte, die zumindest abschnittweise mit elektrischen und / oder elektronischen Bauteilen bestückt ist und die um einen isolierenden Tragekörper herumgelegt und mit diesem verbunden ist.

Hierdurch kann eine einstückige und flächenmäßig relativ große Leiterplatte in einem vergleichsweise kompakten Gehäuse untergebracht werden. Zur Unterbringung einer starren Leiterplatte mit vergleichbarer Fläche bestünden lediglich die Alternativen ein Gehäuse vorzusehen, das eine der Leiterplattengröße vergleichbare Flächengröße aufweist oder in der Verwendung mehrerer kleinflächiger Leiterplatten zwischen denen dann auf aufwendige Weise elektrische Verbindungen hergestellt werden müßten.

Für elektrische oder elektronische Geräte in Kraftfahrzeugen besteht das Problem, daß der zur Verfügung stehende Einbauraum beschränkt ist. Auch wenn die Miniaturisierung elektronischer Bauteile ständig fortschreitet, so wird doch insbesondere durch den sich ständig erweiternden Funktionsumfang, eine gewisse Aufbaufläche zur Verschaltung der Bauteile untereinander und mit der Außenwelt benötigt. Diese Aufbaufläche wird zumeist durch eine Leiterplatte ausgebildet. Mit dem Aufkommen von im weiten Maße flexiblen Leiterplatten ist nun prinzipiell die Möglichkeit gegeben, den vorhandenen Einbauraum vorteilhafter auszunutzen, wobei aber immer noch das Problem besteht, wie ein elektrisches oder elektronisches Gerät in konkreten Fällen auf eine einfache und vorteilhafte Weise ausgeführt werden kann.

Es stellt sich dabei die Aufgabe der Erfindung, ein besonderes kompakt aufgebautes elektrisches Gerät mit einer biegsamen Leiterplatte zu schaffen, bei dem die Leiterplatte auf einfache und kostengünstige Weise eng anliegend und mechanisch stabil auf dem Tragekörper befestigt ist.

Diese Aufgabe wird erfindungsgemäß dadurch gelöst, daß der Tragekörper Befestigungspunkte für die Leiterplatte aufweist, die als stiftförmige Anformungen an dem Tragekörper ausgeführt sind, welche in Ausnehmungen der Leiterplatte eingreifen und deren flachgebügelten Stirnflächen die Leiterplatte unverlierbar mit dem Tragekörper verbinden.

Besonders einfach und vorteilhaft können so die Befestigungspunkte als auf dem Tragekörper angeformte Stifte ausgeführt sein und die Ausnehmungen der Leiterplatte durchgreifen. Durch Erwärmung ("Bügeln") können die die Leiterplatte durchdringenden Abschnitte der Stifte plastisch verformt werden, wodurch die Leiterplatte dauerhaft an dem Tragekörper befestigt wird.

Weitere vorteilhafte Ausgestaltungen und Weiterbildungen des erfindungsgemäßen elektrischen oder elektronischen Gerätes gehen aus den Unteransprüchen hervor.

Es ist vorteilhaft, daß der Tragekörper Biegekanten aufweist. Hierdurch wird verhindert, daß die biegsame Leiterplatte oder die auf der Leiterplatte aufgebrachten Leiterbahnen in den Biegebereichen beschädigt werden.

Eine besonders gute Nutzung des Tragekörpers kann dadurch erreicht werden, daß die Leiterplatte um mehrere oder alle Außenflächen des Tragekörpers herumgelegt ist. Hierdurch kann eine besonders große Leiterplattenfläche auf dem Tragekörper angeordnet werden.

Vorteilhaft ist auch, daß der Tragekörper in seinem Inneren einen Hohlraum ausbildet. Hierdurch können in dem Hohlraum vorteilhafterweise, insbesondere großbauende Schaltungsteile (wie zum Beispiel Relais) angeordnet werden. Dabei erweist es sich als besonders vorteilhaft, daß die Herstellung elektrischer Verbindungen zwischen den im Hohlraum angeordneten Bauteilen und der um den Hohlraum herum angeordneten Leiterplatte auf einfache Weise erfolgen kann; im einfachsten Fall zum Beispiel dadurch, daß die insbesondere großbauenden Schaltungsteile auf den (bezüglich des Tragekörpers) innenliegenden Flächen der Leiterplatte angeordnet werden.

Angeformte Teile des Tragekörpers, können des weiteren auch spezifische Geräteteile, z. B. ein Schaltergehäuse, ausbilden.

Zum Schutz des elektrischen oder elektronisches Gerätes ist es vorteilhaft, die Anordnung aus Leiterplatte und Tragekörper mit einem Gehäuse zu umgeben. Dies kann auf besonders einfache Weise dadurch geschehen, daß Teile des Tragekörpers mit dem Gerätegehäuse verrastet werden. Hierbei ist besonders vorteilhaft, wenn Schaltungsteile die elektrische Verbindung nach außerhalb des Gerätes ausbilden, wie zum Beispiel Sicherungsträger, Steckerstifte oder Steckerbuchsen, direkt auf der Leiterplatte aufgebracht und mit dieser elektrisch verbunden sind und daß diese Schaltungsteile so ausgeführt sind, daß sie Teile des Gerätegehäuses ausbilden, die mit weiteren Gehäuseteilen auf einfache Weise verrastet werden. Hierzu ist es vorteilhaft, wenn der Tragekörper mit Rasthaken versehen ist.

Weiterhin ist es vorteilhaft, wenn der Tragekörper Einzugshaken aufweist, entlang derer das Gehäuseteil bei der Montage geführt wird, wodurch eine zielgerichtete Bewegung und Positionierung der mit dem Gehäuseteil verbundenen Leiterplatte ermöglicht wird.

Hieraus ergibt sich der Vorteil einer besonders einfachen und kostengünstigen Montage des elektrischen oder elektronischen Gerätes.

Besonders vorteilhaft ist, daß alle (oder zumindest fast alle) elektrischen Verbindungen über Leiterbahnen der biegsamen Leiterplatte geführt werden können und so die Herstellung von elektrischen Verbindungen über Drähte oder Kabel-"Bäume" überflüssig ist, was ebenfalls erheblich zu einer kostengünstigen und einfach auszuführenden Montage des elektrischen oder elektronischen Gerätes beiträgt. Vorteilhaft ist eine größere Funktionssicherheit durch weniger Lötstellen.

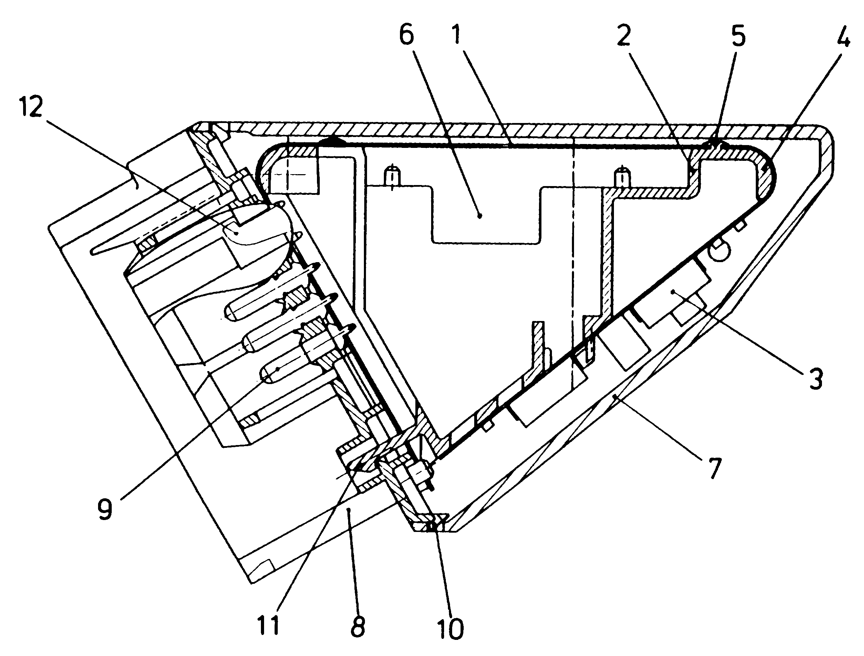

Ein Ausführungsbeispiel eines erfindungsgemäßen elektrischen oder elektronischen Gerätes ist in der Zeichnung dargestellt und soll im folgenden anhand der Zeichung näher erläutert werden.

Die einzige Figur zeigt eine Schnittzeichnung durch ein erfindungsgemäßes elektrisches oder elektronisches Gerät.

Die biegsame Leiterplatte (1) bildet dabei, praktisch in Form einer "Bespannung" des Tragekörpers (2) eine aus drei planen Flächen zusammengesetzte Mantelfläche des Tragekörpers (2) aus. Die im Querschnitt etwa dreieckförmige Leiterplattenkontur ist an den Biegestellen zum Schutz der Leiterplatte (1) etwas abgerundet. Der Tragekörper (2) weist hierzu im Bereich der Biegestellen abgerundete Biegekanten (4) auf.

Im unteren Bereich der Leiterplatte (1) sind zwei Befestigungspunkte (5) dargestellt. Diese sind als stiftförmige Anformungen des Tragekörpers (2) ausgebildet, die durch Flachbügeln des Ausnehmungen der Leiterplatte (1) durchdringenden Abschnitts die Leiterplatte (1) am Tragekörper (2) fixieren. In anderen Abschnitten der Leiterplatte (1) sind selbstverständlich weitere solche Befestigungspunkte vorgesehen, die aber in der Figur nicht dargestellt sind.

Ein erster Flächenabschnitt der Leiterplatte (1) ist mit elektrischen und/oder elektronischen Bauteilen (3) bestückt; ein zweiter Flächenabschnitt der Leiterplatte (1) trägt Steckerstifte (9). Der dritte (untere) Flächenabschnitt der Leiterplatte (1) kann ebenfalls auf seiner Innen- oder Außenseite mit elektrischen oder elektronischen Bauteilen bestückt sein oder aber auch die elektrischen Verbindungen zu (in der Figur nicht dargestellten) Bauteilen herstellen, die in dem im Inneren des Tragekörpers (2) gebildeten Hohlraum (6) angeordnet sein können. Der Tragekörper (2) ist mit (nicht dargestellten) Rastverbindungen mit einem Gehäuse (7) verbunden.

Der die Steckerstifte (9) umfassende Steckerkorb (8), der mit der Leiterplatte (1) mechanisch verbunden ist, bildet ebenfalls ein Teil des Gehäuses aus, das mit dem übrigen Gehäuse (Teil) (7) über Rastverbindungen (10) und mit dem Tragekörper über Rasthaken (11) verbunden ist, wodurch ein besonders stabiler Zusammenhalt des Gehäuses mit der Anordnung aus Tragekörper (2) und Leiterplatte (1) erzielt wird.

Beim Verrasten des Steckerkorbes (8) mit dem Tragekörper (2) wird dieser entlang von Einzugshaken (12) des Tragekörpers (2) geführt, wodurch der mit dem Steckerkorb verbundene Leiterbahnabschnitt exakt gebogen und positioniert wird.

### Bezugszeichenliste

Elektrisches oder elektronisches Gerät für ein Kraftfahrzeug
- 1: (biegsame) Leiterplatte
- 2: Tragekörper
- 3: elektrische oder elektronische Bauteile
- 4: (abgerundete) Biegekanten
- 5: Befestigungspunkte
- 6: Hohlraum
- 7: Gehäuse
- 8: Gehäuseteil (Steckerkorb)
- 9: Steckerstifte
- 10: Rastverbindung
- 11: Rasthaken
- 12: Einzugshaken

## Patentansprüche

1. Elektrisches oder elektronisches Gerät für ein Kraftfahrzeug, mit einer biegsamen Leiterplatte (1), die zumindest abschnittsweise mit elektrischen und/oder elektronischen Bauteilen (3) bestückt ist und die um einen isolierenden Tragekörper (2) herumgelegt und mit diesem verbunden ist, dadurch gekennzeichnet, daß der Tragekörper (2) Befestigungspunkte (5) für die Leiterplatte (1) aufweist, die als stiftförmige Anformungen an dem Tragekörper (2) ausgeführt sind, welche in Ausnehmungen der Leiterplatte (1) eingreifen und deren flachgebügelten Stirnflächen die Leiterplatte (1) unverlierbar mit dem Tragekörper (2) verbinden.

2. Elektrisches oder elektronisches Gerät nach Anspruch 1, dadurch gekennzeichnet, daß die Leiterplatte (1) um mehrere oder alle Außenflächen des Tragekörpers (2) herumgelegt ist.

3. Elektrisches oder elektronisches Gerät nach Anspruch 1, dadurch gekennzeichnet, daß der Tragekörper (2) in seinem Inneren einen Hohlraum (6) ausbildet, in dem Schaltungsteile angeordnet sind.

4. Elektrisches oder elektronisches Gerät nach Anspruch 1, dadurch gekennzeichnet, daß der Tragekörper (2) einstückig ein Schaltergehäuse ausbildet.

5. Elektrisches oder elektronisches Gerät nach Anspruch 1, dadurch gekennzeichnet, daß der Tragekörper (2) und die Leiterplatte (1) durch ein Gehäuse (7) umschlossen werden.

6. Elektrisches oder elektronisches Gerät nach Anspruch 5, dadurch gekennzeichnet, daß der Tragekörper (2) über Rastverbindungen mit dem Gehäuse verbunden ist.

7. Elektrisches oder elektronisches Gerät nach Anspruch 5, dadurch gekennzeichnet, daß mindestens ein Teil (8) des Gehäuses (7), insbesondere ein Sicherungshalter oder Steckerkorb, mit der Leiterplatte (1) verbunden ist.

8. Elektrisches oder elektronisches Gerät nach Anspruch 7, dadurch gekennzeichnet, daß das Gehäuseteil (8) mittels Rasthaken (11) mit dem Tragekörper (2) verbunden ist.

9. Elektrisches oder elektronisches Gerät nach Anspruch 7, dadurch gekennzeichnet, daß der Tragekörper (2) Einzugshaken (12) aufweist, und daß das Gehäuseteil (8) beim Verbinden mit dem Tragekörper (2) entlang der Einzugshaken (12) geführt wird.

## Claims

1. An electrical or electronic device for a motor vehicle, comprising a flexible printed board (1) which is equipped, at least sectionally, with electrical and/or electronic components (3) and which is placed round an insulating supporting body (2) and is attached thereto, characterised in that the supporting body (2) comprises fixing points (5) for the printed board (1) which are constructed as pin-like formations on the supporting body (2) which fit into apertures in the printed board (1), the end faces of which pin-like formations are pressed flat and captively join the printed board (1) to the supporting body (2).

2. An electrical or electronic device according to claim 1, characterised in that the printed board (1) is placed round a plurality of or round all of the external faces of the supporting body (2).

3. An electrical or electronic device according to claim 1, characterised in that the supporting body (2) forms a cavity (6) in its interior in which circuit parts are disposed.

4. An electrical or electronic device according to claim 1, characterised in that the supporting body (2) forms a circuit housing as one piece.

5. An electrical or electronic device according to claim 1, characterised in that the supporting body (2) and the printed board (1) are enclosed by a housing (7).

6. An electrical or electronic device according to claim 5, characterised in that the supporting body (2) is attached to the housing via snap-in connections.

7. An electrical or electronic device according to claim 5, characterised in that at least one part (8) of the housing (7), particularly a fuse holder or a plug-in frame, is attached to the printed board (1).

8. An electrical or electronic device according to claim 7, characterised in that the housing part (8) is attached to the supporting body (2) by means of snap-in hooks (11).

9. An electrical or electronic device according to claim 7, characterised in that the supporting body (2) has feed hooks (12), and the housing part (8) is guided along the feed hooks (12) when it is attached to the supporting body (2).

## Revendications

1. Appareil électrique ou électronique pour un véhicule automobile, comportant une plaquette à circuits imprimés flexible (1), qui est équipée, au moins par endroits, de composants électriques et/ou électroniques (3) et qui est disposée autour d'un corps de support isolant (2) et est reliée à ce dernier, caractérisé en ce que le corps de support (2) comporte des points de fixation (5) pour la plaquette à circuits imprimés (1), qui sont agencés sous la forme de parties conformées en forme de tiges présentes sur le corps de support (2) et qui s'engagent dans des ouvertures de la plaquette à circuits imprimés (1) et dont les faces frontales aplaties par repassage relient la plaquette à circuits imprimés (1) d'une manière imperdable au corps de support (2).

2. Appareil électrique ou électronique selon la revendication 1, caractérisé en ce que la plaquette à circuits imprimés (1) est disposée autour de plusieurs ou de toutes les surfaces extérieures du corps de support (2).

3. Appareil électrique ou électronique selon la revendication 1, caractérisé en ce que le corps de support (2) définit, en son intérieur, une cavité (6) dans laquelle sont disposés des éléments de circuits.

4. Appareil électrique ou électronique selon la revendication 1, caractérisé en ce que le corps de support (2) constitue, sous forme monobloc, un boîtier d'interrupteur.

5. Appareil électrique ou électronique selon la revendication 1, caractérisé en ce que le corps de support (2) et la plaquette à circuits imprimés (1) sont entourés par un boîtier (7).

6. Appareil électrique ou électronique selon la revendication 5, caractérisé en ce que le corps de support (2) est relié au boîtier par l'intermédiaire de systèmes de liaison à encliquetage.

7. Appareil électrique ou électronique selon la revendication 5, caractérisé en ce qu'au moins une partie (8) du boîtier (7), notamment un dispositif de retenue de sécurité ou un manchon enveloppant de connecteur est relié à la plaquette à circuits imprimés (1).

8. Appareil électrique ou électronique selon la revendication 7, caractérisé en ce que la partie (8) du boîtier est reliée au moyen de crochets d'encliquetage (11) au corps de support (2).

9. Appareil électrique ou électronique selon la revendication 7, caractérisé en ce que le corps de support (2) comporte des crochets d'introduction (12) et que lors de l'établissement de la liaison avec le corps de support (2), la partie (8) du boîtier est guidée le long des crochets d'introduction (12).
